# EUROPEAN PATENT APPLICATION

(11) **EP 3 758 080 A1**
(43) Date of publication of application: **30.12.2020**
(21) Application number: 19757264.7
(22) Date of filing: 20.02.2019
(51) Int. Cl.: H01L 35/14, B22F 1/00, B22F 3/10, C04B 35/58, C22C 1/04, C22C 13/00, C22C 23/00, H01L 35/34

(54) **THERMOELECTRIC CONVERSION MATERIAL, THERMOELECTRIC CONVERSION ELEMENT, AND THERMOELECTRIC CONVERSION MODULE**

(30) Priority: 20.02.2018 JP 2018028144
(71) Applicant: Mitsubishi Materials Corporation, Tokyo 100-8117 (JP)
(72) Inventor: NAKADA Yoshinobu, Saitama-shi, Saitama 330-8508 (JP)
(74) Representative: Hoffmann Eitle
(86) International application number: PCT/JP2019/006242
(87) International publication number: WO 2019/163807

(57) **Abstract**

A thermoelectric conversion material is provided, consisting of a sintered body of a compound containing a dopant, in which a calculated standard deviation of a dopant concentration, which is obtained by measuring the dopant concentration for each of a plurality of compound particles observed in a section of the sintered body, is 0.15 or less. Here, the compound is preferably one or more selected from a MgSi-based compound, a MnSi-based compound, a SiGe-based compound, a MgSiSn-based compound, and a MgSn-based compound.

## Description

### TECHNICAL FIELD

The present invention relates to a thermoelectric conversion material having excellent thermoelectric property, a thermoelectric conversion element using the same, and a thermoelectric conversion module.

Priority is claimed on Japanese Patent Application No. 2018-028144, filed on February 20, 2018, the content of which is incorporated herein by reference.

### BACKGROUND ART

A thermoelectric conversion element formed of a thermoelectric conversion material is an electronic element capable of mutually converting heat and electricity, as in the Seebeck effect and Peltier effect. The Seebeck effect is an effect of converting heat energy into electric energy, and is a phenomenon in which an electromotive force is generated when a temperature difference is generated between both ends of a thermoelectric conversion material. Such an electromotive force depends on characteristics of the thermoelectric conversion material. In recent years, thermoelectric power generation utilizing the effect has been actively developed.

The thermoelectric conversion element described above has a structure in which electrodes are each formed on one end and the other end of the thermoelectric conversion material.

As an index representing thermoelectric property of the thermoelectric conversion element (thermoelectric conversion material), for example, a power factor (PF) represented by Equation (1) below or a dimensionless performance index (ZT) represented by Equation (2) below is used. In the thermoelectric conversion material, it is necessary to maintain a temperature difference between one surface side and the other surface side. Therefore, it is preferable that the thermoelectric conversion material have low thermal conductivity. $PF = {S}^{2} σ$ (1) S: Seebeck coefficient (V/K), σ: Electric conductivity (S/m) $ZT = {S}^{2} σ T / κ$ (2) T = Absolute temperature (K), κ = Thermal conductivity (W/(m × K))

Here, as the thermoelectric conversion material described above, for example, as shown in Patent Document 1 and Non-Patent Document 1, a material obtained by adding various dopants to magnesium silicide is proposed.

A thermoelectric conversion material disclosed in Patent Document 1 is manufactured by sintering a raw material powder adjusted to have a predetermined composition.

### [Citation List]

### [Patent Document]

[Patent Document 1]
Japanese Unexamined Patent Application, First Publication No. 2013-179322

### [Non-Patent Document]

[Non-Patent Document 1]
J Tani, H Kido, "Thermoelectric properties of Sb-doped Mg2Si semiconductors", Intermetallics 15 (2007) 1202-1207

### SUMMARY OF INVENTION

### Technical Problem

However, in Patent Document 1 and Non-Patent Document 1 described above, a concentration of the dopant to be added is specified so that the various indexes described above reach target values.

However, even in thermoelectric conversion materials having the same dopant concentration, the thermoelectric property varied in some cases.

For this reason, in a thermoelectric conversion device using a thermoelectric conversion element formed of a thermoelectric conversion material, there is a concern that required performance cannot be stably exhibited.

The present invention was made in view of circumstances described above, and an object of the present invention is to provide a thermoelectric conversion material that has excellent thermoelectric property and is stable, a thermoelectric conversion element using the same, and a thermoelectric conversion module.

### Solution to Problem

In order to solve the problems described above, the present inventors conducted intensive studies. As a result, it was found that, in a thermoelectric conversion material consisting of a sintered body, a dopant concentration varies among crystal grains (particles) of the sintered body, and accordingly, the thermoelectric property of the entire thermoelectric conversion material changes. Therefore, the thermoelectric property of the entire thermoelectric conversion material deteriorates due to a state varied in the dopant concentration among crystal grains (particles).

The present invention was made based on the findings described above. According to an aspect of the present invention, a thermoelectric conversion material is provided, consisting of a sintered body of a compound containing a dopant, in which a calculated standard deviation of a dopant concentration, which is obtained by measuring the dopant concentration for each of a plurality of compound particles observed in a section of the sintered body, is 0.15 or less.

In the thermoelectric conversion material with this configuration, since the standard deviation of the dopant concentration measured for each of the plurality of compound particles observed in the section of the sintered body is 0.15 or less and variation in the dopant concentration is suppressed between the plurality of compound particles, it is possible to stably provide a thermoelectric conversion material having excellent thermoelectric property.

Here, in the thermoelectric conversion material of the present invention, the compound is preferably one or more selected from a MgSi-based compound, a MnSi-based compound, a SiGe-based compound, a MgSiSn-based compound, and a MgSn-based compound.

In this case, since the compound forming the sintered body is one or more selected from the MgSi-based compound, the MnSi-based compound, the SiGe-based compound, the MgSiSn-based compound, and the MgSn-based compound, a thermoelectric conversion material having further excellent thermoelectric property can be obtained.

In addition, in the thermoelectric conversion material of the present invention, the dopant is preferably one or more selected from Li, Na, K, B, Al, Ga, In, N, P, As, Sb, Bi, Ag, Cu, and Y.

In this case, a specific semiconductor type (that is, an n-type or a p-type) of a thermoelectric conversion material can be obtained by using the elements described above as a dopant.

According to another aspect of the present invention, a thermoelectric conversion element is provided, including: the thermoelectric conversion material described above; and electrodes each joined to one surface of the thermoelectric conversion material and the other surface opposite the one surface.

According to the thermoelectric conversion element with this configuration, since the thermoelectric conversion element includes the thermoelectric conversion material described above, a thermoelectric conversion element having excellent thermoelectric property can be obtained.

According to still another aspect of the present invention, a thermoelectric conversion module is provided, including: the thermoelectric conversion element described above; and terminals each joined to the electrodes of the thermoelectric conversion element.

According to the thermoelectric conversion module with this configuration, since the thermoelectric conversion module includes the thermoelectric conversion element including the thermoelectric conversion material described above, a thermoelectric conversion module having excellent thermoelectric property can be obtained.

### Advantageous Effects of Invention

According to the present invention, it is possible to provide a thermoelectric conversion material having excellent thermoelectric property and is stable, a thermoelectric conversion element using the same, and a thermoelectric conversion module.

### BRIEF DESCRIPTION OF DRAWINGS

Fig. 1 is a sectional view showing a thermoelectric conversion material according to an embodiment of the present invention, a thermoelectric conversion element using the same, and a thermoelectric conversion module.
Fig. 2 is a flowchart showing an example of a method for manufacturing a thermoelectric conversion material according to an embodiment of the present invention.
Fig. 3 is a sectional view showing an example of a sintering apparatus used in the method for manufacturing a thermoelectric conversion material shown in Fig. 2.
Fig. 4 is an explanatory diagram showing a position at which a dopant concentration of a compound particle is measured in Examples.

### DESCRIPTION OF EMBODIMENTS

Hereinafter, a thermoelectric conversion material according to an embodiment of the present invention, a thermoelectric conversion element using the same, and a thermoelectric conversion module will be described with reference to the accompanying drawings. Each embodiment to be described below is specifically described for better understanding of the gist of the invention, and does not limit the present invention unless otherwise specified. In addition, in the drawings used in the following description, for convenience, in order to make the features of the present invention easy to understand, a portion that is a main part may be enlarged in some cases, and a dimensional ratio or the like of each component is not always the same as an actual one.

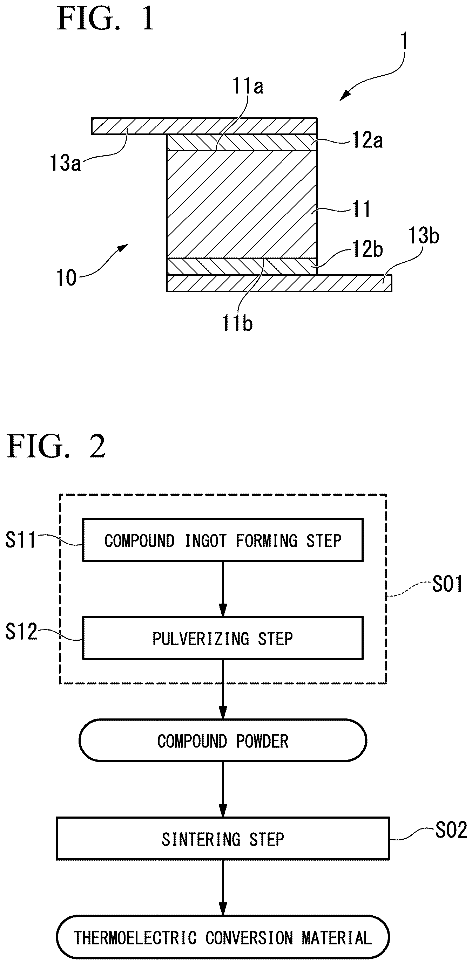

Fig. 1 shows a thermoelectric conversion material 11 according to an embodiment of the present invention, a thermoelectric conversion element 10 using the thermoelectric conversion material 11, and a thermoelectric conversion module 1.

The thermoelectric conversion module 1 shown in Fig. 1 includes the thermoelectric conversion material 11 according to the present embodiment, electrodes 12a and 12b respectively formed on one surface 11a of the thermoelectric conversion material 11 and the other surface 11b opposite the one surface, and terminals 13a and 13b respectively connected to the electrodes 12a and 12b.

A part including the thermoelectric conversion material 11 and the electrodes 12a and 12b forms the thermoelectric conversion element 10.

For the electrodes 12a and 12b, nickel, silver, cobalt, tungsten, molybdenum, or the like is used. The electrodes 12a and 12b can be formed by electric sintering, plating, electrodeposition, or the like.

The terminals 13a and 13b are formed of a metal material having excellent conductivity, for example, a plate material such as copper or aluminum. In the present embodiment, a rolled aluminum plate is used. In addition, the electrodes 12a and 12b and the terminals 13a and 13b of the thermoelectric conversion element 10 can be respectively joined together, by Ag brazing, Ag plating, or the like.

Thus, the thermoelectric conversion material 11 in the present embodiment is formed by a sintered body of a compound containing a dopant.

Here, the compound forming the sintered body is preferably one or more selected from a MgSi-based compound, a MnSi-based compound, a SiGe-based compound, a MgSiSn-based compound, and a MgSn-based compound.

It is preferable that a content of the compound forming the sintered body be 95.0 atomic% to 99.95 atomic% in 100 atomic% of the total amount of the thermoelectric conversion material in terms of atomic percentage.

It is preferable that the content of the compound forming the sintered body be 87.4 mass% to 99.9955 mass% in 100 mass% of the total amount of the thermoelectric conversion material in terms of mass percentage.

In the present embodiment, as the compound forming the sintered body, magnesium silicide (Mg₂Si) is used.

In addition, it is preferable that as the dopant contained in the compound, one or more selected from Li, Na, K, B, Al, Ga, In, N, P, As, Sb, Bi, Ag, Cu, and Y be used.

It is preferable that a content of the dopant be 0.05 atomic% to 5 atomic% in 100 atomic% of the total amount of the thermoelectric conversion material in terms of atomic percentage.

It is preferable that the content of the dopant be 0.0045 mass% to 13.6 mass% in 100 mass% of the total amount of the thermoelectric conversion material in terms of mass percentage.

In the present embodiment, antimony (Sb) is added as the dopant.

That is, the thermoelectric conversion material 11 of the present embodiment has a composition in which magnesium silicide (Mg₂Si) contains antimony in a range of 0.16 mass% or more and 3.4 mass% or less. In the thermoelectric conversion material 11 of the present embodiment, an n-type thermoelectric conversion material having a high carrier density is obtained by adding the antimony which is a pentavalent donor.

Thus, in the thermoelectric conversion material 11 according to the present embodiment, a calculated standard deviation of a dopant concentration (Sb concentration), which is obtained by measuring the dopant concentration (Sb concentration) for each of a plurality of compound particles (magnesium silicide particles) observed in a section of the sintered body, is 0.15 or less.

That is, in the present embodiment, variation in the dopant concentration (Sb concentration) between the compound particles (magnesium silicide particles) is suppressed.

The dopant concentration (Sb concentration) of the compound particles (magnesium silicide particles) is measured by irradiating the center (center of gravity) of the compound particle with an electron beam, for example, using an EPMA apparatus.

In addition, in the present embodiment, the dopant concentration is measured in five or more compound particles, and the standard deviation of the dopant concentration is calculated.

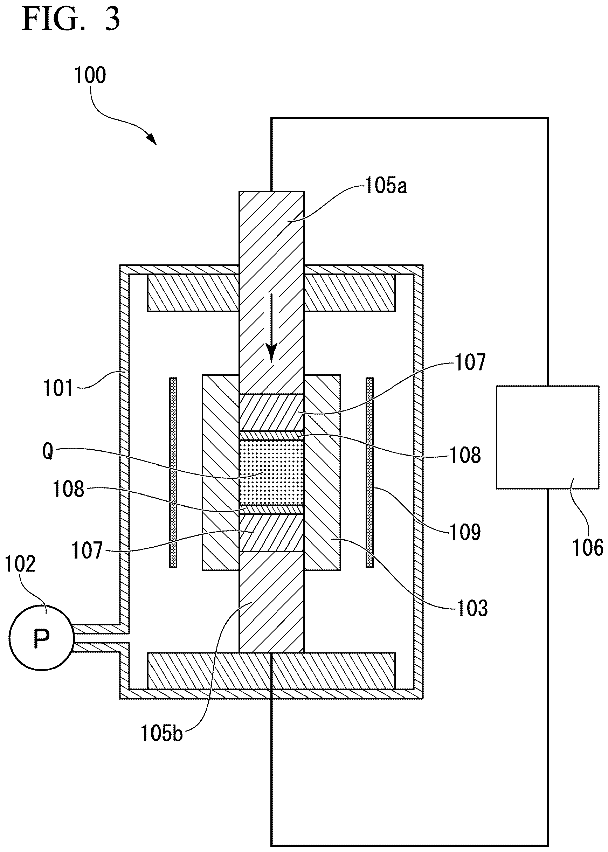

Hereinafter, an example of a method for manufacturing the thermoelectric conversion material 11 according to the present embodiment described above will be described with reference to Figs 2 and 3.

### (Compound powder preparation step S01)

First, a powder of a compound (magnesium silicide), which is a parent phase of the sintered body of the thermoelectric conversion material 11, is manufactured.

In the present embodiment, a compound powder preparing step S01 includes a compound ingot-forming step S11 for obtaining an ingot of a compound (magnesium silicide) containing a dopant, and a pulverizing step S12 of pulverizing the compound ingot (magnesium silicide) to obtain a compound powder (magnesium silicide powder).

In the compound ingot-forming step S11, a raw material powder to be melted and a dopant powder are each weighed and mixed together. In the present embodiment, since the compound is magnesium silicide, the raw material powder to be melted is a silicon powder and a magnesium powder. In addition, since antimony (Sb) is used as the dopant, the dopant powder is an antimony (Sb) powder.

Here, in the present embodiment, an addition amount of the antimony (Sb) as the dopant is set in a range of 0.16 mass% or more and 3.4 mass% or less.

In addition, since a small amount of magnesium sublimates during heating for melting, it is preferable to add a large amount of magnesium, for example, approximately 5 at% to a stoichiometric composition of Mg:Si = 2:1 when measuring the raw materials.

Then, the weighed raw material powder to be melted and the dopant powder are charged into a crucible in an atmosphere melting furnace, melted in a hydrogen atmosphere, and then cooled and solidified. Accordingly, a compound (magnesium silicide) ingot containing a dopant is manufactured.

By setting the melting atmosphere to the hydrogen atmosphere (100 volume% hydrogen atmosphere), thermal conductivity in a furnace improves, a cooling rate during solidification can be made relatively high, and the dopant concentration in the ingot is made uniform. In addition, hydrogen makes a reducing atmosphere and an oxide film present on a surface of the raw material powder to be melted and the dopant powder is removed. Accordingly, the compound (magnesium silicide) ingot having a small amount of oxygen is obtained.

Here, in the present embodiment, it is preferable that a heating temperature during melting be in a range of 1000°C or higher and 1230°C or lower. In addition, it is preferable that a cooling rate until 600°C during solidification be in a range of 5°C/min or higher and 50°C/min lower.

In the pulverizing step S12, the obtained compound (magnesium silicide) ingot is pulverized by a pulverizer to form a compound powder (magnesium silicide powder) containing a dopant.

An average particle size of the compound powder (magnesium silicide powder) is preferably in a range of 0.5 µm or larger and 100 µm or smaller.

Here, in the present embodiment, since the compound ingot in which the dopant concentration is made uniform is pulverized as described above, the dopant concentration becomes uniform between the compound powders (magnesium silicide powders).

### (Sintering step S02)

Then, the sintering raw material powder made of the compound powder (magnesium silicide powder) obtained as described above is heated while applying pressure to obtain a sintered body.

In the present embodiment, in the sintering step S02, a sintering apparatus (an electric sintering apparatus 100) shown in Fig. 3 is used.

The sintering apparatus (electric sintering apparatus 100) shown in Fig. 3 includes, for example, a pressure-resistant housing 101, a vacuum pump 102 for reducing the pressure inside the pressure-resistant housing 101, and a hollow cylindrical carbon mold 103 disposed inside the pressure-resistant housing 101, a pair of electrode portions 105a and 105b for applying a current while pressing a sintering raw material powder Q with which the carbon mold 103 is filled, and a power supply device 106 for applying a voltage between the pair of electrode portions 105a and 105b. In addition, a carbon plate 107 and a carbon sheet 108 are respectively provided between the electrode portions 105a and 105b and the sintering raw material powder Q. In addition to these, a thermometer, a displacement gauge, and the like (which are not shown) are provided.

In addition, in the present embodiment, a heater 109 is provided on an outer peripheral side of the carbon mold 103. The heater 109 is disposed on four sides so as to cover the entire outer peripheral side of the carbon mold 103. As the heater 109, a carbon heater, a nichrome wire heater, a molybdenum heater, a Kanthal wire heater, a high-frequency heater, or the like can be used.

In a sintering step S03, first, the carbon mold 103 of the electric sintering apparatus 100 shown in Fig. 3 is filled with the sintering raw material powder Q. For example, an inside of the carbon mold 103 is covered with a graphite sheet or a carbon sheet. Then, a direct current is applied between the pair of electrode portions 105a and 105b by using the power supply device 106, and the current is applied to the sintering raw material powder Q. Accordingly, a temperature increases by self-heating (electric heating). In addition, between the pair of electrode portions 105a and 105b, the electrode portion 105a on a movable side is caused to move toward the sintering raw material powder Q, and the sintering raw material powder Q is pressed at a predetermined pressure between the electrode portion 105a and the electrode portion 105b on a fixed side. In addition, the heater 109 is heated.

Accordingly, the sintering raw material powder Q is sintered by the self-heating of the sintering raw material powder Q, the heat from the heater 109, and the pressing.

In the present embodiment, sintering conditions in the sintering step S03 are as follows: a sintering temperature of the sintering raw material powder Q is in a range of 800°C or higher and 1030°C or lower, and a holding time at the sintering temperature is in a range of 0 minutes or longer and 5 minutes or shorter. In addition, pressing load is in a range of 15 MPa or more and 60 MPa or less.

In addition, an atmosphere in the pressure-resistant housing 101 may be an inert atmosphere such as an argon atmosphere or a vacuum atmosphere. When the vacuum atmosphere is set, the pressure may be set to 5 Pa or less.

Thus, in the sintering step S03, when the direct current is applied to the sintering raw material powder Q, polarities of the one electrode portion 105a and the other electrode portion 105b change at a predetermined time interval. That is, an energizing state in which the one electrode portion 105a is used as an anode and the other electrode portion 105b is used as a cathode, and an energizing state in which the one electrode portion 105a is used as a cathode and the other electrode portion 105b is used as an anode are implemented alternately. In the present embodiment, the predetermined time interval is set within a range of 15 seconds or longer and to 300 seconds or shorter.

According to the above steps, the thermoelectric conversion material 11 according to the present embodiment is manufactured. Since the compound powder (magnesium silicide powder) in which the dopant concentration is made uniform is used as the sintering raw material powder as described above, the dopant concentration (Sb concentration) between the compound particles (magnesium silicide particles) in the sintered body is made uniform.

According to the present embodiment with the above-described configuration, the thermoelectric conversion material 11 is formed of the sintered body of the compound containing the dopant (magnesium silicide containing Sb), and the standard deviation of the dopant concentration (Sb concentration) measured for each of the plurality of compound particles (magnesium silicide particles) observed in a section of the sintered body is 0.15 or less. Therefore, variation in the dopant concentration (Sb concentration) between the plurality of compound particles (magnesium silicide particles) is suppressed, and the thermoelectric conversion material 11 having excellent thermoelectric property can be obtained.

In addition, in the present embodiment, since the compound forming the sintered body is one or more selected from the MgSi-based compound, the MnSi-based compound, the SiGe-based compound, the MgSiSn-based compound, and the MgSn-based compound, the thermoelectric conversion material 11 having further excellent thermoelectric property can be obtained.

In particular, in the present embodiment, since the compound forming the sintered body is the magnesium silicide (Mg2Si), particularly excellent thermoelectric property can be obtained and it is possible to improve thermoelectric conversion efficiency.

Further, in the present embodiment, since as the dopant contained in the compound, one or more selected from Li, Na, K, B, Al, Ga, In, N, P, As, Sb, Bi, Ag, Cu, and Y are used, a specific semiconductor type (that is, an n-type or a p-type) of a thermoelectric conversion material can be obtained.

In particular, in the present embodiment, since antimony (Sb) is used as the dopant, the thermoelectric conversion material can be suitably used as an n-type thermoelectric conversion material with a high carrier density.

The thermoelectric conversion element 10 and the thermoelectric conversion module 1 according to the present embodiment include the thermoelectric conversion material 11 described above, and thus have excellent thermoelectric property. Accordingly, it is possible to configure a thermoelectric conversion device having excellent thermoelectric conversion efficiency.

As described above, the embodiments of the present invention are described. However, the present invention is not limited thereto, and can be appropriately modified without departing from the technical idea of the present invention.

For example, in the present embodiment, it was described that the thermoelectric conversion element and the thermoelectric conversion module having a structure as shown in Fig. 1 are configured. However, the present invention is not limited thereto, and there is no particular limitation on a structure and disposition of the electrodes or terminals, as long as the thermoelectric conversion material of the present embodiment is used.

Further, in the present embodiment, it was described that antimony (Sb) is used as the dopant, but the present invention is not limited thereto. For example, one or more selected from Li, Na, K, B, Al, Ga, In, N, P, As, Bi, Ag, Cu, and Y may be contained as the dopant, or these elements may be contained in addition to Sb.

In the present embodiment, it was described that the compound forming the sintered body is magnesium silicide (Mg₂Si). However, the present invention is not limited thereto, and a compound having another composition may be used, as long as the compound has a thermoelectric property.

### [Examples]

Hereinafter, results of experiments performed to confirm the effects of the present invention will be described.

### (Example 1)

Mg with a purity of 99.9 mass% (manufactured by Kojundo Chemical Lab. Co., Ltd., average particle size of 180 µm), Si with a purity of 99.99 mass% (manufactured by Kojundo Chemical Lab. Co., Ltd., average particle size of 300 µm), and Sb with a purity of 99.9 mass% (manufactured by Kojundo Chemical Lab. Co., Ltd., average particle size of 300 µm) were weighed. In consideration of deviation from Mg:Si = 2:1 of a stoichiometric composition due to sublimation of Mg, Mg was mixed by 5 at% more.

Here, in Example 1, a target value of a Sb content was set to 1.0 mass%. That is, Sb was mixed at 1.0 mass%.

In the present example, the weighed raw material powder described above was charged into a crucible in an atmosphere melting furnace, melted in a hydrogen atmosphere, and then cooled and solidified. A heating temperature during melting was set to 1200°C, and after holding for 60 minutes, a cooling rate until 600°C during solidification was set to 10°C/min. Accordingly, an ingot of the compound (magnesium silicide) containing a dopant was manufactured.

Next, the ingot was pulverized and classified to obtain an Sb-containing magnesium silicide powder having an average particle size of 30 µm (Present Example 1-1).

In Present Example 1-2, an Sb-containing magnesium silicide powder was obtained in the same manner as in Present Example 1-1 except that the heating temperature during melting was set to 1150°C. In Present Example 1-3, an Sb-containing magnesium silicide powder was obtained in the same manner as in Present Example 1-1 except that the heating temperature during melting was set to 1120°C. In Present Example 1-4, an Sb-containing magnesium silicide powder was obtained in the same manner as in Present Example 1-1 except that the holding time during melting was set to 30 minutes.

On the other hand, in comparative examples, the above-described raw material powder weighed in the same manner as in Present Example 1-1 was mixed by a mechanical alloying device to obtain an Sb-containing magnesium silicide powder. In Comparative Example 1-1, mechanical alloying time was set to 15 hours, and in Comparative Example 1-2, the mechanical alloying time was set to 10 hours.

A carbon mold whose inside was covered with a carbon sheet was filled with the obtained Sb-containing magnesium silicide powder. Thus, electric sintering was performed by the sintering apparatus (electric sintering apparatus 100) shown in Fig. 3. The electric sintering conditions were set to atmosphere: vacuum (5 Pa or less), sintering temperature: 1000°C, holding time at the sintering temperature: 30 seconds, and pressure load: 40 MPa.

In this manner, the thermoelectric conversion materials of Present Examples 1-1 to 1-4 and Comparative Examples 1-1 and 1-2 were obtained.

For the obtained thermoelectric conversion materials, the standard deviation of the dopant concentration between the plurality of compound particles and the thermoelectric property were evaluated with the following procedure.

### (Standard deviation of dopant concentration)

A measurement sample was collected from each of the obtained thermoelectric conversion materials and a cut surface was polished. A secondary electron image and a reflected electron image at an acceleration voltage of 15 kV, a beam current of 50 nA, and a beam diameter of 1 µm were observed using an EPMA apparatus (JXA-8800RL manufactured by JEOL Ltd.) and the compound particle was specified from the images. Then, at the center (center of gravity) of the specified compound particles, elemental analysis was performed using the above-described EPMA apparatus at an acceleration voltage of 15 kV, a beam current of 50 nA, and a beam diameter of 5 µm, and an Sb concentration was measured.

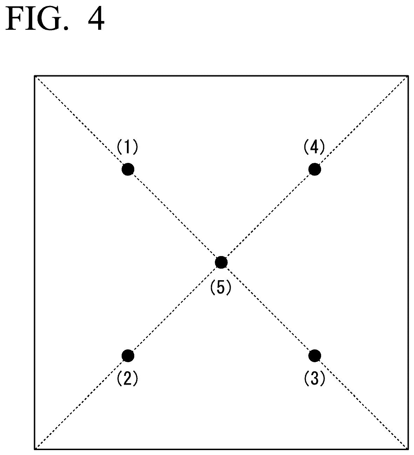

For an observation region of 200 µm × 200 µm, as shown in Fig. 4, two diagonal lines were drawn, and the dopant concentrations of the compound particles near five points of four center points (1), (2), (3), (4) of four 1/2 diagonal lines based on the intersection of the diagonal lines, and the intersection (5) of the diagonal lines were measured. The measurement was performed in two visual fields, and an average value and a standard deviation of the dopant concentration were calculated from measured values of total 10 points. Table 1 shows the measurement results.

### (Thermoelectric property)

Regarding the thermoelectric property, 4 mm x 4 mm x 15 mm of rectangular parallelepiped was cut out from the sintered thermoelectric conversion material, and power factors (PF) of each of the samples at 100°C, 200°C, 300°C, 400°C, 500°C, and 550°C were determined using a thermoelectric property evaluation device (ZEM-3 manufactured by ADVANCE RIKO, Inc.). A PF value measurement temperature in Table 1 is 550°C, which is a temperature at which the maximum power factor among the power factors at each of the temperatures is shown.

**[Table 1]**

| | | | Present Example 1-1 | Present Example 1-2 | Present Example 1-3 | Present Example 1-4 | Comparative Example 1-1 | Comparative Example 1-2 |
|---|---|---|---|---|---|---|---|---|
| Manufacturing method for sintering raw material powder | | | Melting in hydrogen atmosphere | Melting in hydrogen atmosphere | Melting in hydrogen atmosphere | Melting in hydrogen atmosphere | Mechanical alloying for 15 hours | Mechanical alloying for 10 hours |
| Dopant concentration (mass%) | Visual field 1 | (1) | 0.93 | 0.82 | 0.79 | 0.71 | 1.99 | 1.86 |
| | | (2) | 0.84 | 0.88 | 0.99 | 0.94 | 1.03 | 0.07 |
| | | (3) | 0.84 | 1.23 | 0.95 | 0.76 | 0.11 | 2.35 |
| | | (4) | 1.04 | 1.09 | 0.96 | 0.78 | 0.64 | 1.20 |
| | | (5) | 1.04 | 1.02 | 0.60 | 0.90 | 1.35 | 0.94 |
| | Visual field 2 | (1) | 0.81 | 1.02 | 1.00 | 0.76 | 1.79 | 0.25 |
| | | (2) | 0.98 | 0.89 | 0.93 | 0.69 | 0.93 | 0.81 |
| | | (3) | 1.09 | 0.95 | 0.89 | 0.90 | 0.61 | 0.74 |
| | | (4) | 1.02 | 0.90 | 0.70 | 0.92 | 0.70 | 0.89 |
| | | (5) | 1.01 | 1.05 | 0.66 | 0.93 | 1.69 | 0.69 |
| | Average value | | 0.96 | 0.98 | 0.85 | 0.83 | 1.08 | 0.98 |
| | Standard deviation | | 0.100 | 0.124 | 0.148 | 0.098 | 0.606 | 0.688 |
| PF(×10⁻³W/(m·K²)) | | | 3.422 | 3.332 | 3.007 | 3.651 | 2.300 | 2.193 |

In Comparative Examples 1-1 and 1-2 in which the Sb-containing magnesium silicide powder as the sintering raw material was formed by the mechanical alloying device, the standard deviation of the dopant concentration increased to 0.6 or more. It is presumed that in the mechanical alloying, a compound powder having a uniform dopant concentration could not be obtained.

Thus, in the thermoelectric conversion materials of Comparative Examples 1-1 and 1-2, the power factor (PF) was low, and the thermoelectric property was insufficient.

On the other hand, in Present Examples 1-1 to 1-4 obtained by pulverizing the ingot obtained by melting and casting the Sb-containing magnesium silicide powder as a sintering raw material in a hydrogen atmosphere, the standard deviation of the dopant concentration was suppressed to 0.15 or less.

In the thermoelectric conversion materials of Present Examples 1-1 to 1-4, the power factor (PF) was sufficiently high and the thermoelectric property was excellent.

### (Example 2)

In Present Examples 2-1 and 2-2, the raw material powder of the thermoelectric conversion material described in Table 2 and the dopant powder described in Table 2 were charged into a crucible in an atmosphere melting furnace and melted in a hydrogen atmosphere, and then cooled and solidified. A heating temperature during melting was set to 900°C, and a cooling rate until 600°C during solidification was set to 5°C/min. Accordingly, an ingot of the thermoelectric conversion material containing a dopant was manufactured. Next, the ingot was pulverized and classified to obtain a powder of a dopant-containing thermoelectric conversion material having an average particle size of 30 µm.

For Mg, Si, and Sb, the same raw materials as in Example 1 were used. For Sn, Sn with a purity of 99.99 mass% (manufactured by Kojundo Chemical Lab. Co., Ltd., average particle size of 63 µm) was used.

Mg, Si, and Sn were weighed and mixed based on the stoichiometric composition shown in Table 2. That is, in Mg₂SiSn, Mg:Si:Sn = 2:1:1, and in Mg₂Sn, Mg:Sn = 2:1. In addition, in consideration of deviation from the stoichiometric composition in the same manner as in Example 1, Mg was mixed by 5 at% more.

Sb as a dopant was added by weighing the target values shown in Table 2.

In Comparative Examples 2-1 and 2-2, the raw material powder and the dopant powder were mixed together by the mechanical alloying device to obtain a dopant-containing thermoelectric conversion material powder. In Comparative Example 2-1, mechanical alloying time was set to 15 hours, and in Comparative Example 2-2, the mechanical alloying time was set to 10 hours.

In Present Example 2-1 and Comparative Example 2-1, the target value of the Sb content was set to 0.31 mass%. In Present Example 2-2 and Comparative Example 2-2, the target value of the Sb content was set to 0.36 mass%. That is, adding was performed by weighing the target values shown in Table 2.

The obtained dopant-containing thermoelectric conversion material powder was electrically sintered to obtain thermoelectric conversion materials of Present Examples 2-1 and 2-2 and Comparative Examples 2-1 and 2-2.

The electric sintering conditions of Mg₂SiSn were set to atmosphere: vacuum (5 Pa or less), sintering temperature: 750°C, holding time at the sintering temperature: 30 seconds, and pressure load: 30 MPa.

The electric sintering conditions of Mg₂Sn were set to atmosphere: vacuum (5 Pa or less), sintering temperature: 700°C, holding time at the sintering temperature: 30 seconds, and pressure load: 30 MPa.

Regarding the obtained thermoelectric conversion material, the standard deviation of the dopant concentration among the plurality of compound particles and the thermoelectric property were evaluated in the same manner as in Example 1.

For the evaluation of the thermoelectric property, the power factors (PF) at 100°C, 200°C, 300°C, 350°C, 400°C, and 450°C were determined for the Mg₂SiSn, and the power factors (PF) at 50°C, 100°C, 150°C, 200°C, 250°C, and 300°C were determined for the Mg₂Sn. "PF measurement temperature" in Table 2 refers to a temperature at which the largest power factor was shown among the power factors at the above-described temperatures.

These temperatures are the temperatures at which the largest power factor in the measurement range of each sample was shown.

**[Table 2]**

| | | | Present Example 2-1 | Comparative Example 2-1 | Present Example 2-2 | Comparative Example 2-2 |
|---|---|---|---|---|---|---|
| Thermoelectric conversion material | | | Mg₂SiSn | Mg₂SiSn | Mg₂Sn | Mg₂Sn |
| Kind of dopant | | | Sb | Sb | Sb | Sb |
| Target concentration of dopant | | | 0.31 mass% | 0.31 mass% | 0.36 mass% | 0.36 mass% |
| Manufacturing method for sintering raw material powder | | | Melting in hydrogen atmosphere | Mechanical alloying for 15 hours | Melting in hydrogen atmosphere | Mechanical alloying for 10 hours |
| Dopant concentration (mass%) | Visual field 1 | (1) | 0.25 | 0.09 | 0.31 | 0.47 |
| | | (2) | 0.31 | 0.17 | 0.35 | 1.12 |
| | | (3) | 0.29 | 0.29 | 0.22 | 0.15 |
| | | (4) | 0.33 | 0.20 | 0.41 | 0.28 |
| | | (5) | 0.40 | 0.98 | 0.29 | 0.10 |
| | Visual field 2 | (1) | 0.35 | 0.52 | 0.39 | 0.07 |
| | | (2) | 0.27 | 0.13 | 0.29 | 0.35 |
| | | (3) | 0.27 | 1.02 | 0.43 | 0.84 |
| | | (4) | 0.36 | 0.03 | 0.34 | 0.17 |
| | | (5) | 0.23 | 0.05 | 0.33 | 0.14 |
| | Average value | | 0.31 | 0.35 | 0.34 | 0.37 |
| | Standard deviation | | 0.054 | 0.371 | 0.063 | 0.351 |
| PF(×10⁻³W/(m·K²)) | | | 1.8 | 1.2 | 2.1 | 1.4 |
| PF measurement temperature | | | 400°C | 400°C | 50°C | 50°C |

In Present Examples 2-1 and 2-2, even in a case where Mg₂SiSn or Mg₂Sn was used as the thermoelectric conversion material, an ingot obtained by melting and casting the dopant-containing thermoelectric conversion material powder as a raw material in a hydrogen atmosphere was pulverized to obtain the thermoelectric conversion material. Accordingly, the standard deviation of the dopant concentration was suppressed to 0.15 or less.

Thus, the thermoelectric conversion materials of Present Examples 2-1 and 2-2 had sufficient high-power factor (PF) and had excellent thermoelectric property.

From the above, it was confirmed that according to the present examples, it is possible to provide a thermoelectric conversion material having excellent thermoelectric property.

### [Reference Signs List]

- 1: Thermoelectric conversion module
- 10: Thermoelectric conversion element
- 11: Thermoelectric conversion material
- 12a, 12b: Electrode
- 13a, 13b: Terminal

## Claims

1. A thermoelectric conversion material, consisting of:
a sintered body of a compound containing a dopant,
wherein a calculated standard deviation of a dopant concentration, which is obtained by measuring the dopant concentration for each of a plurality of compound particles observed in a section of the sintered body, is 0.15 or less.

2. The thermoelectric conversion material according to Claim 1,
wherein the compound is one or more selected from a MgSi-based compound, a MnSi-based compound, a SiGe-based compound, a MgSiSn-based compound, and a MgSn-based compound.

3. The thermoelectric conversion material according to Claim 1 or 2,
wherein the dopant is one or more selected from Li, Na, K, B, Al, Ga, In, N, P, As, Sb, Bi, Ag, Cu, and Y.

4. A thermoelectric conversion element, comprising:
the thermoelectric conversion material according to any one of Claims 1 to 3; and
electrodes each joined to one surface of the thermoelectric conversion material and the other surface opposite the one surface.

5. A thermoelectric conversion module, comprising:
the thermoelectric conversion element according to Claim 4; and
terminals each joined to the electrodes of the thermoelectric conversion element.
